# EUROPÄISCHE PATENTSCHRIFT

(11) **EP 1 142 026 B1**
(45) Veröffentlichungstag und Bekanntmachung des Hinweises auf die Patenterteilung: **14.11.2007**
(21) Anmeldenummer: 99966821.3
(22) Anmeldetag: 01.12.1999
(51) Int. Cl.: H01L 29/739

(54) **LEISTUNGSHALBLEITERSCHALTER**
POWER SEMICONDUCTOR SWITCH
COMMUTATEUR STATIQUE DE PUISSANCE

(30) Priorität: 04.12.1998 DE 19856104
(43) Veröffentlichungstag der Anmeldung: 10.10.2001
(73) Patentinhaber: Infineon Technologies AG, 81669 München (DE)
(72) Erfinder: REZNIK, Daniel, D-80686 München (DE)
(74) Vertreter: Viering, Jentschura & Partner
(86) Internationale Anmeldenummer: PCT/DE1999/003836
(87) Internationale Veröffentlichungsnummer: WO 2000/035021

(56) Entgegenhaltungen:
- EP-A- 0 837 508
- WO-A-98/38681
- US-A- 5 608 237
- US-A- 5 766 966
- MORI M ET AL: "A NOVEL HIGH-CONDUCTIVITY IGBT (HIGT) WITH A SHORT CIRCUIT CAPABILITY" INTERNATIONAL SYMPOSIUM ON POWER SEMICONDUCTOR DEVICES & IC'S,US,NEW YORK, NY: IEEE,3. Juni 1998 (1998-06-03), Seiten 429-432, XP000801108 ISBN: 0-7803-4752-8

## Beschreibung

Die vorliegende Erfindung betrifft ein Bauelement, z.B. einen IGBT (Insulated Gate Bipolar Transistor), der zur Ausbildung bidirektionaler Schalter geeignet ist.

Mit Hilfe handelsüblicher IGBTs können bidirektionale Schalter aufgebaut werden, die z. B. in Umrichtern eingesetzt werden, indem jeder IGBT in Reihe mit einer Diode geschaltet wird. Die Durchlaßrichtung der Diode stimmt dabei mit der schaltbaren Stromrichtung des IGBTs überein. Diese Schaltung sperrt daher in der Rückwärtsrichtung. Es sind damit allerdings hohe Durchlaßverluste in Kauf zu nehmen. In der US 5,608,237 ist ein bidirektionaler Halbleiterschalter aus IGBTs beschrieben, bei dem IGBT-Strukturen an zwei einander gegenüberliegenden Hauptseiten eines Halbleiterkörpers ausgebildet sind. Die Dimensionierung derartiger Vorschläge für bidirektional sperrende Schalter ist jeweils so gewählt, daß sich ein NPT-Bauelement (Non Punch Through) ergibt. Unter Sperrbelastung baut sich im Bauelement ein dreiecksförmiges Feldprofil auf. Andere symmetrisch sperrende Bauelemente wie z. B. Thyristoren oder GTOs weisen ebenfalls eine Non-Punch-Through-Dimensionierung auf. Das macht eine hohe Dicke des Bauelementes erforderlich und erhöht damit die Schalt- und Durchlaßverluste gegenüber der dünneren Punch-Through-Dimensionierung.

Aufgabe der vorliegenden Erfindung ist es, einen einfach konzipierten Schalter anzugeben, der in beiden Richtungen hohe Spannungen sperren kann. Diese Aufgabe wird mit dem Bauelement mit den Merkmalen des Anspruches 1 gelöst. Ausgestaltungen ergeben sich aus dem abhängigen Anspruch.

Bei dem erfindungsgemäßen Bauelement wird eine herkömmliche Struktur eines Leistungshalbleiterschalters, z. B. eines IGBTs, mit einer zusätzlichen Pufferschicht auf der Source-Seite versehen und so dimensioniert, daß in einem Betriebszustand, in dem das Bauelement sperrt, zumindest in einem Bereich hoher elektrischer Spannungen, die an Source und Drain angelegt werden, eine in dem Halbleiterkörper entstehende Raumladungszone entsprechend einer Punch-Through-Dimensionierung bis an die jeweilige Pufferschicht heranreicht. Die zusätzliche Pufferschicht ist so hoch dotiert (mit einer Dosis von mehr als 1·10¹² cm⁻² bis 4·10¹² cm⁻²), daß bei einer Umpolung der Spannung zwischen Drain und Source gewissermaßen der Punch-Through-Fall für die Gegenrichtung vorliegt, so daß das Bauelement hohe Spannungen in beiden Richtungen sperrt. Durch die beidseitig vorhandenen Pufferschichten wird der Vorteil der Punch-Through-Dimensionierung (geringe Dicke des Bauelementes) mit dem Vorteil der Non-Punch-Through-Dimensionierung (Möglichkeit der symmetrischen Sperrfähigkeit) kombiniert.

Ein IGBT, der eine zwischen beiden Basisbereichen angeordneten Schicht aufweist, ist aus der EP-A-0837508 bekannt.

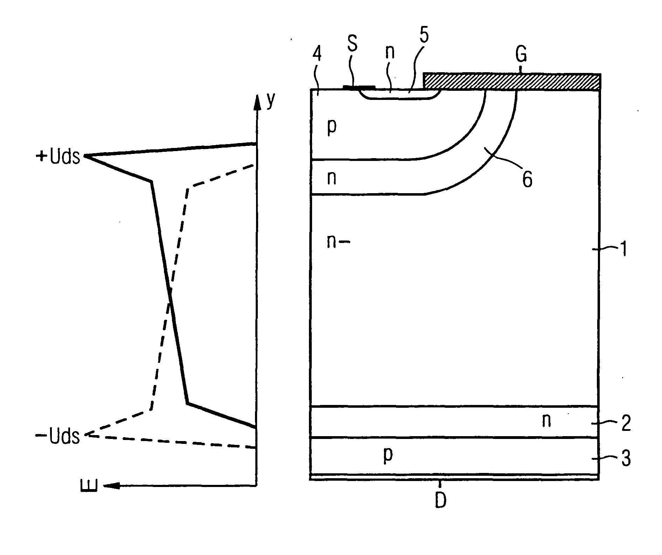

Es folgt eine genauere Beschreibung des erfindungsgemäßen Bauelementes anhand des in der Figur im Querschnitt dargestellten Beispiels.

In der Figur ist auf der rechten Seite im Querschnitt ein Ausschnitt aus einer IGBT-Struktur dargestellt. Ein erster Basisbereich 1 wird im wesentlichen durch den mit einer Grunddotierung versehenen Halbleiterkörper gebildet. Diese Grunddotierung ist vorzugsweise eine Dotierung für schwache n-Leitfähigkeit. Entsprechend einer an sich bekannten IGBT-Struktur sind ein zweiter Basisbereich 4 entgegengesetzten Vorzeichens und Emitterbereiche 3, 5 vorhanden. Die Abfolge dieser Bereiche besitzt in vertikaler Richtung wechselnde Vorzeichen der Leitfähigkeit. In dem zweiten Basisbereich 4, der bis an die Oberseite des Halbleiterkörpers heranreichend ausgebildet ist, wird an dieser Oberseite ein Kanal ausgebildet, der mittels einer darüber angebrachten und vorzugsweise durch ein Dielektrikum davon getrennten Gate-Elektrode G gesteuert werden kann. Der zweite.Basisbereich 4 ist vorzugsweise als p-leitend dotierte Wanne in dem n⁻-leitend dotierten Halbleiterkörper ausgebildet. Innerhalb dieser Wanne befindet sich der entgegengesetzt dazu dotierte Bereich 5 (in diesem Beispiel n-leitend), der mit dem Source-Kontakt S verbunden ist, der auch den zweiten Basisbereich 4 kontaktiert.

Auf der Rückseite des Bauelementes befindet sich ein weiterer dotierter Bereich 3, der als Emitter-Bereich entgegengesetzt zu dem ersten Basisbereich 1 dotiert und mit einem Drain-Kontakt D versehen ist. Entsprechend einer an sich bekannten Punch-Through-Dimensionierung ist die Dicke des Halbleiterkörpers gegenüber IGBTs mit Non-Punch-Through-Dimensionierung geringer gewählt, und es ist eine Pufferschicht 2 desselben Vorzeichens der Leitfähigkeit wie der erste Basisbereich 1, zwischen dem ersten Basisbereich 1 und dem mit dem Drain-Kontakt versehenen Bereich (p-Emitter) angeordnet. Diese Pufferschicht 2 ist vorzugsweise mit einer Dosis von 1·10¹² cm⁻² bis 4·10¹² cm⁻² dotiert (Integral über das Dotierungsprofil). In sperrendem Betriebszustand des Bauelementes fällt im Gegensatz zur herkömmlichen Schichtstruktur mit Pufferschicht das elektrische Feld zu einem großen Teil in dem ersten Basisbereich 1 ab. Ein typischer Verlauf des elektrischen Feldes in vertikaler Richtung des Bauelementes ist auf der linken Seite der Figur dargestellt für den Fall, daß der Drain-Anschluß gegenüber dem Source-Anschluß positiv ist (durchgezogene Kurve in dem y-E-Diagramm).

Wesentlich für die Erfindung ist eine weitere Pufferschicht 6, die zwischen dem ersten Basisbereich 1 und dem zweiten Basisbereich 4 vorhanden ist, und die für elektrische Leitfähigkeit desselben Vorzeichens wie der erste Basisbereich 1 (Grunddotierung des Halbleiterkörpers) dotiert ist. Diese in diesem Beispiel n-leitende weitere pufferschicht 6 ist so hoch dotiert (mit einer Dosis von mehr als 1·10¹² cm⁻² bis 4·10¹² cm⁻²), daß bei einer Umpolung der Spannung zwischen Drain und Source sich ein Verlauf des elektrischen Feldes in vertikaler Richtung des Bauelementes ergibt, der im Prinzip der in dem Diagramm auf der linken Seite der Figur eingezeichneten gestrichelten Kurve entspricht. Es liegt hier gewissermaßen der Punch-Through-Fall für die Gegenrichtung vor, so daß dieses Bauelement auch hohe Spannungen in beiden Richtungen sperrt. Der sperrende Betriebszustand wird in an sich bekannter Weise in den von Source nach Drain geöffneten Betriebszustand überführt mittels der Steuerung des Kanals über die Gate-Elektrode. Es liegt daher erfindungsgemäß ein Bauelement vor, das in einer Stromrichtung einen Schalter darstellt und in Gegenrichtung bis zu hohen Spannungen den Strom sperrt.

Vorzugsweise wird die Grunddotierung des Halbleiterkörpers etwas niedriger gewählt als sonst üblich (z. B. für 1200-V-IGBTs 90 Qcm statt 60 Ωcm). Die Dicke und die Höhe der Dotierung in dem ersten Basisbereich 1 und den beiden Pufferschichten 2, 6 sind genau zu dimensionieren; bei zu hoher Dotierung und/oder Dicke der Schichten erfolgt ein verfrühter Durchbruch aufgrund der Lawinenmultiplikation der Ladungsträger (Avalanche-Effekt), bei zu niedriger Dotierung der Pufferschichten erfolgt ein Durchbruch aufgrund von Punch-Through des gesperrten PNP-Transistors. Bei richtiger Dimensionierung, die anhand der üblichen Vorgehensweisen für das jeweilige Ausführungsbeispiel leicht gefunden werden kann, kann die Dicke des Bauelementes reduziert werden. Außerdem bewirkt die weitere Pufferschicht 6 unter der p-leitend dotierten Wanne in dem Halbleiterkörper eine Anhebung der Ladurigsträgerdichte in diesem Bereich, so daß die Schaltverluste verringert werden und eine Verbesserung um ca. 30-40 % bei gleichbleibenden Durchlaßverlusten möglich ist. Damit ist ein symmetrisch sperrender 1200 V IGBT realisierbar, ebenso symmetrisch sperrende Thyristoren oder GTOs.

## Patentansprüche

1. Bauelement mit einem Halbleiterkörper, in dem
zwischen zwei Hauptseiten übereinander vier dotierte Bereiche (3, 1, 4, 5) wechselnden Vorzeichens der Leitfähigkeit ausgebildet sind, von denen
ein Bereich als erster Basisbereich (1) eine niedrige Grunddotierung des Halbleiterkörpers aufweist und
ein weiterer Bereich dazu entgegengesetzten Vorzeichens der Leitfähigkeit als zweiter Basisbereich (4) bis an eine der Hauptseiten heranreichend ausgebildet und derart mit einer an dieser Hauptseite vorhandenen Gate-Elektrode (G) versehen ist, daß ein in dem zweiten Basisbereich (4) ausgebildeter Kanal gesteuert werden kann, und
die beiden übrigen Bereiche (5, 3) mit einem Source-Kontakt (S), der auch den zweiten Basisbereich (4) kontaktiert und auf derselben Hauptseite wie die Gate-Elektrode angebracht ist, bzw. mit einem Drain-Kontakt (D) versehen sind,
wobei zwischen dem ersten Basisbereich (1) und dem mit dem Drain-Kontakt (D) versehenen Bereich (3) ein weiterer Bereich, der für dasselbe Vorzeichen der Leitfähigkeit wie der erste Basisbereich dotiert ist, als Pufferschicht (2) vorhanden ist und
der erste Basisbereich (1) so dimensioniert ist und die Höhe der Dotierung der Pufferschicht (2) so gewählt ist, daß in einem Betriebszustand, in dem das Bauelement in Richtung vom Source-Kontakt (S) zum Drain-Kontakt (D) hin sperrt, zumindest in einem vorgesehenen Bereich angelegter elektrischer Spannungen eine in dem ersten Basisbereich (1) vorhandene Raumladungszone mindestens bis an die Pufferschicht (2) heranreichend ausgebildet ist,
bei dem
zwischen dem ersten Basisbereich (1) und dem zweiten Basisbereich (4) eine weitere Pufferschicht (6) vorhanden ist, die für dasselbe Vorzeichen der Leitfähigkeit wie der erste Basisbereich (1) dotiert ist, und
die weitere Pufferschicht (6) mit einer Dosis von mehr als 1·10¹² cm⁻² bis 4·10¹² cm⁻² dotiert ist, so daß das Bauelement in einem Bereich entgegengesetzter angelegter, hoher elektrischer Spannungen in Richtung vom Drain-Kontakt (D) zum Source-Kontakt (S) hin sperrt.

2. Bauelement nach Anspruch 1,
bei dem die Höhe der Dotierung der weiteren Pufferschicht (6) so gewählt ist, daß in einem Betriebszustand, in dem das Bauelement in Richtung vom Drain-Kontakt (D) zum Source-Kontakt (S) hin sperrt, zumindest in einem Bereich angelegter, hoher elektrischer Spannungen eine in dem ersten Basisbereich (1) vorhandene Raumladungszone mindestens bis an die weitere Pufferschicht (6) heranreichend ausgebildet ist.

## Claims

1. A component having a semiconductor body, in which four doped regions (1, 3, 4, 5) whose conductivities have alternating signs are formed one above the other between two main sides, of which regions
one region, as first base region (1), has a low basic doping of the semiconductor body, and
a further region, whose conductivity has an opposite sign to that of the former region, is formed as second base region (4) in a manner extending as far as one of the main sides and is provided with a gate electrode (G), which is present on said main side, in such a way that a channel formed in the second base region (4) can be controlled, and
the two remaining regions (3, 5) are provided with a source contact (S), which also makes contact with the second base region (4) and is applied on the same main side as the gate electrode, or respectively with a drain contact (D),
in which case a further region, which is doped such that its conductivity has the same sign as the first base region, is present as buffer layer (2) between the first base region (1) and the region (3) provided with the drain contact (D), and
the first base region (1) is dimensioned in such a way, and the magnitude of the doping of the buffer layer (2) is chosen in such a way, that, in an operating state in which the component effects blocking in the direction from the source contact (S) toward the drain contact (D), at least in an envisaged range of applied electrical voltages, a space charge zone present in the first base region (1) is formed in a manner extending at least as far as the buffer layer (2),
wherein
a further buffer layer (6), which is doped such that its conductivity has the same sign as the first base region (1), is present between the first base region (1) and the second base region (4), and
the magnitude of the doping of the further buffer layer (6) is chosen as more than 1* 10¹² cm⁻² to 4* 10¹² cm⁻² such that the component effects blocking in the direction from the drain contact (D) toward the source contact (S) in a range of opposite applied high electrical voltages.

2. The component as claimed in claim 1,
in which the magnitude of the doping of the further buffer layer (6) is chosen in such a way that, in an operating state in which the component effects blocking in the direction from the drain contact (D) toward the source contact (S), at least in a range of applied electrical high voltages, a space charge zone present in the first base region (1) is formed in a manner extending at least as far as the further buffer layer (6).

## Revendications

1. Composant ayant un corps semiconducteur, dans lequel sont formés entre deux faces principales de façon superposées quatre zones (3, 1, 4, 5) dopées de signes de conductivité alternés, dont
une zone a comme première zone (1) de base un dopage de base petit du corps semiconducteur, et
une autre zone de signe opposé de la conductivité est formée en tant que deuxième zone (4) de base en allant jusqu'à l'une des faces principales et est munie d'une électrode (G) de grille présente sur cette face principale de sorte qu'un canal formé dans la deuxième zone (4) de base peut être commandé, et
les deux autres zones (5, 3) sont munies d'un contact (S) de source qui est aussi en contact avec la deuxième zone (4) de base, et qui est disposé sur la même face principale que l'électrode de grille, et d'un contact (D) de drain,
dans lequel entre la première zone (1) de base et la zone (3) munie du contact (D) de drain, il y a en tant que couche (2) tampon une autre zone qui est dopée en ayant le même signe de la conductivité que la première zone de base, et
la première zone (1) de base a des dimensions telles et le niveau du dopage de la couche (2) tampon est choisi de telle façon que dans un état de fonctionnement dans lequel le composant bloque dans le sens allant du contact (S) de source au contact (D) de drain, il est formé au moins dans une plage prévue de tensions électriques appliquées une zone de charge d'espace présente dans la première zone (1) de base allant au moins jusqu'à la couche tampon (2),
dans lequel entre la première zone (1) de base et la deuxième zone (4) de base il y a une autre couche (6) tampon qui est dopée de manière à avoir le même signe de la conductivité que la première zone (1) de base, et
l'autre couche (6) tampon est dopée par une dose de plus de 1·10¹² cm⁻² jusqu'à 4·10¹² cm⁻² de sorte que le composant bloque dans une plage plus haute de tension électrique appliquée opposée dans le sens allant du contact (D) de drain au contact (S) de source.

2. Composant suivant la revendication 1,
dans lequel le niveau du dopage de l'autre couche (6) tampon est choisie de manière à ce que dans un état de fonctionnement dans lequel le composant bloque dans le sens allant du contact (D) de drain au contact (S) de source, au moins dans une plage de tensions électriques plus haute appliquée, il est formé une zone de charge d'espace présente dans la première zone (1) de base allant au moins jusqu'à l'autre couche (6) tampon.
